# EUROPEAN PATENT APPLICATION

(11) **EP 4 531 526 A1**
(43) Date of publication of application: **02.04.2025**
(21) Application number: 24200016.4
(22) Date of filing: 12.09.2024
(51) Int. Cl.: H10K 59/126, H10K 59/80, H10K 71/80

(54) **DISPLAY MODULE**

(30) Priority: 26.09.2023 KR 20230129684
(71) Applicant: Samsung Display Co., Ltd., Gyeonggi-do 17113 (KR)
(72) Inventor: LEE, Dong-Bum, 17113 Yongin-si (KR); KIM, Kwangsoo, 17113 Yongin-si (KR); PARK, Sukjae, 17113 Yongin-si (KR); JEONG, Yoolpyo, 17113 Yongin-si (KR)
(74) Representative: Marks & Clerk LLP

(57) **Abstract**

A display module according to an embodiment may include a display panel including a plurality of pixels, a cover panel disposed under the display panel and including a shielding layer including a metal, and a protective film disposed under the cover panel. The protective film may include a conductive adhesive layer disposed under the shielding layer and having conductivity, a protective layer disposed under the conductive adhesive layer and including a recess portion exposing a portion of the conductive adhesive layer, and a protruding member disposed under the conductive adhesive layer, having conductivity, and including a first portion overlapping the portion of the conductive adhesive layer exposed by the recess portion of the protective layer and a second portion extending from the first portion in a first direction.

## Description

### BACKGROUND

### 1. FIELD

Embodiments of the present inventive concept relate to a display module. More particularly, embodiments of the present inventive concept relate to a display module during a process in providing or manufacturing an electronic device.

### 2. DESCRIPTION OF THE RELATED ART

A display module may include a display panel on which an image is displayed, and a cover panel and a protective film disposed under the display panel. After removing the protective film from the display module, an electronic device may be manufactured by assembly with various sets. The protective film may protect the display panel and the cover panel until the display panel and the cover panel are assembled with the set.

During the manufacturing process of the electronic device, static electricity may flow into the display panel. When static electricity flowing into the display panel is not discharged to the outside, element characteristics of transistors included in the display panel may change. Therefore, not only after assembly with the set but also before assembly with the set, it is necessary to discharge static electricity flowing into the display panel to the outside.

### SUMMARY

Embodiments of the present inventive concept provide a display module with improved reliability.

Additional features of the inventive concepts will be set forth in the description which follows, and in part will be apparent from the description, or may be learned by practice of the inventive concepts.

A display module according to an embodiment includes a display panel including a plurality of pixels, a cover panel disposed under the display panel and including a shielding layer including a metal, and a protective film disposed under the cover panel. The protective film includes a conductive adhesive layer disposed under the shielding layer and having conductivity, a protective layer disposed under the conductive adhesive layer and including a recess portion exposing a portion of the conductive adhesive layer, and a protruding member disposed under the conductive adhesive layer, having conductivity, and including a first portion overlapping the portion of the conductive adhesive layer exposed by the recess portion of the protective layer and a second portion extending from the first portion in a first direction.

In an embodiment, the conductive adhesive layer may contact a lower surface of the shielding layer, an upper surface of the protective layer, and an upper surface of the first portion of the protruding member.

In an embodiment, a first adhesive force between the lower surface of the shielding layer and an upper surface of the conductive adhesive layer may be less than each of a second adhesive force between a lower surface of the conductive adhesive layer and the upper surface of the protective layer and a third adhesive force between the lower surface of the conductive adhesive layer and the upper surface of the first portion of the protruding member.

In an embodiment, the first portion of the protruding member may overlap the shielding layer in a plan view. The second portion of the protruding member may protrude from the shielding layer in the first direction in a plan view.

In an embodiment, the recess portion of the protective layer may be recessed from an outer edge of the protective layer in a direction opposite to the first direction.

In an embodiment, the conductive adhesive layer may have a planar shape overlapping a planar shape of the shielding layer.

In an embodiment, the protruding member and the shielding layer may include a same material.

In an embodiment, the shielding layer may include a body portion and at least one static electricity induction pattern portion.

In an embodiment, the shielding layer may include a first layer, a second layer disposed under the first layer, electrically connected to the first layer, and including at least one static electricity induction pattern portion, and an adhesive layer disposed between the first layer and the second layer.

In an embodiment, the cover panel may further include an impact absorbing layer including a cushion layer and a heat dissipation layer disposed between the impact absorbing layer and the shielding layer.

A display module according to an embodiment includes a display panel including a plurality of pixels, a cover panel disposed under the display panel and including a shielding layer, the shielding layer including a metal and including a first protrusion protruding in a first direction, and a protective film disposed under the cover panel. The protective film includes an adhesive layer disposed under the shielding layer and a protective layer disposed under the adhesive layer and including a second protrusion, the second protrusion protruding in the first direction, overlapping the first protrusion, and having a size smaller than a size of the first protrusion.

In an embodiment, the adhesive layer may contact a lower surface of the shielding layer and an upper surface of the protective layer. The adhesive layer may expose each of the first protrusion and the second protrusion.

In an embodiment, the first protrusion may include a first portion overlapping the second protrusion and a second portion positioned outside the first portion.

In an embodiment, the second protrusion may expose the second portion of the first protrusion.

In an embodiment, an adhesive force between the lower surface of the shielding layer and an upper surface of the adhesive layer may be less than an adhesive force between a lower surface of the adhesive layer and the upper surface of the protective layer.

In an embodiment, the first protrusion may protrude from a body portion of the shielding layer in the first direction. The shielding layer may have at least one groove formed between the body portion and the first protrusion.

A display module according to an embodiment includes a display panel including a plurality of pixels, a cover panel disposed under the display panel and including a shielding layer including a metal, and a protective film disposed under the cover panel. The protective film includes a conductive adhesive layer disposed under the shielding layer, a protective layer disposed under the conductive adhesive layer and including a body portion having an opening and a protrusion protruding from the body portion in a first direction, and a conductive layer disposed under the conductive adhesive layer, and positioned within the opening of the body portion of the protective layer, and having conductivity.

In an embodiment, the conductive adhesive layer may contact a lower surface of the shielding layer, an upper surface of the protective layer, and an upper surface of the conductive layer.

In an embodiment, an adhesive force between the lower surface of the shielding layer and an upper surface of the conductive adhesive layer may be less than each of an adhesive force between a lower surface of the conductive adhesive layer and the upper surface of the protective layer and an adhesive force between the lower surface of the conductive adhesive layer and the upper surface of the conductive layer.

In an embodiment, the conductive layer may be a single-sided conductive tape having an upper surface with an adhesive property, the upper surface of the single-sided conductive tape contacting the conductive adhesive layer.

At least some of the above and other features of the invention are set out in the claims.

The display module according to embodiments can discharge static electricity flowing into the display panel to the outside even before assembly with the set. Accordingly, reliabilities of the display panel, the display module, and the electronic device may be improved.

It is to be understood that both the foregoing general description and the following detailed description are explanatory and are intended to provide further explanation of the inventive concept as claimed.

### BRIEF DESCRIPTION OF THE DRAWINGS

The accompanying drawings, which are included to provide a further understanding of the inventive concept and are incorporated in and constitute a part of this specification, illustrate embodiments, and together with the description serve to explain the inventive concepts.
FIGS. 1A and 1B are a top view and a rear view illustrating a display module according to an embodiment.
FIG. 2 is a cross-sectional view taken along a line I-I' of FIG. 1A.
FIG. 3 is a cross-sectional view schematically illustrating a display area of a display panel included in the display module of FIGS. 1A and 1B.
FIGS. 4A, 4B, and 4C are rear views illustrating various examples of a shielding layer included in the display module of FIGS. 1A and 1B.
FIGS. 5A and 5B are a top view and a rear view illustrating a display module according to an embodiment.
FIG. 6 is an enlarged view of area A of FIG. 5B.
FIG. 7 is a cross-sectional view taken along a line II-II' of FIG. 5A.
FIGS. 8A and 8B are a top view and a rear view illustrating a display module according to an embodiment.
FIG. 9 is a cross-sectional view taken along a line III-III' of FIG. 8A.

### DETAILED DESCRIPTION

Illustrative, non-limiting embodiments will be more clearly understood from the following detailed description in conjunction with the accompanying drawings.

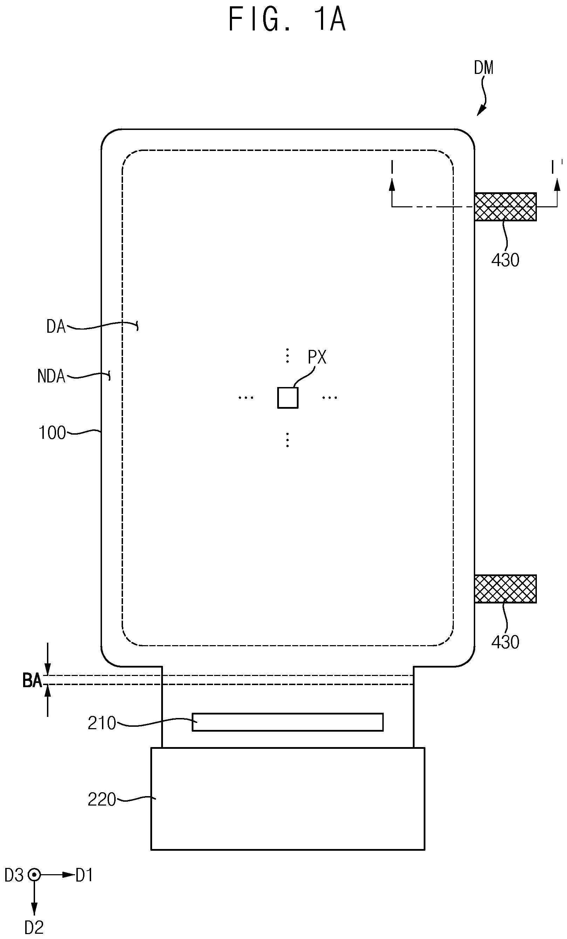

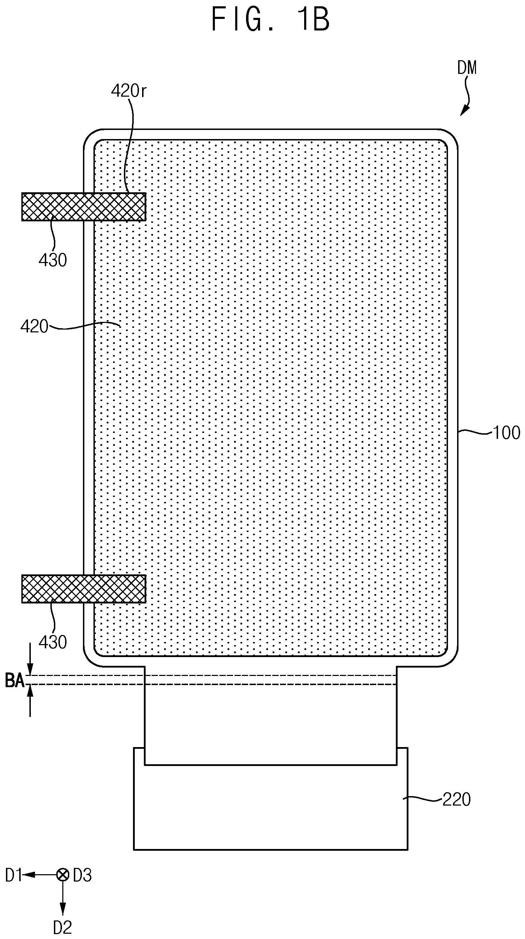

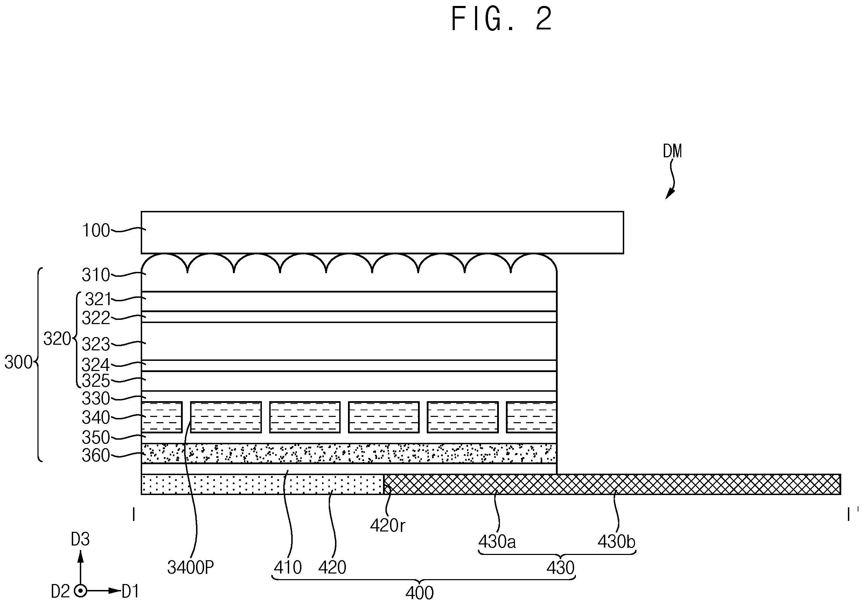

FIGS. 1A and 1B are a top view and a rear view illustrating a display module DM according to an embodiment. FIG. 2 is a cross-sectional view taken along a line I-I' of FIG. 1A.

Referring to FIGS. 1A to 2, a display module DM according to an embodiment may include a display panel 100, a driving circuit chip 210, a circuit board 220, a cover panel 300, and a protective film 400.

The display panel 100 may include a display area DA and a non-display area NDA. A plurality of pixels PX for generating an image may be disposed in the display area DA. The image may be generated by combining lights respectively emitted from the pixels PX. For example, the pixels PX may be arranged in a matrix form along a first direction D1 and a second direction D2 crossing the first direction D1. For example, the second direction D2 may be perpendicular to the first direction D1.

The non-display area NDA may be positioned around the display area DA. For example, the non-display area NDA may surround the display area DA in a plan view.

The non-display area NDA may include a first pad area and a second pad area. For example, the first pad area may be spaced apart from the display area DA in the second direction D2. The second pad area may be spaced apart from the first pad area in the second direction D2.

In an embodiment, the non-display area NDA may include a bending area BA positioned between the display area DA and the first pad area. The bending area BA may be bent along a bending axis extending in the first direction D1. The bending area BA may be bent such that the first pad area and the second pad area are positioned under the display area DA. Hereinafter, an upper direction may refer to a third direction D3, and a lower direction may refer to a direction opposite to the third direction D3.

The driving circuit chip 210 may be disposed in the first pad area on the display panel 100. For example, the driving circuit chip 210 may be directly mounted on the display panel 100 in a chip on plastic (COP) manner, but embodiments are not limited thereto.

The circuit board 220 may be disposed in the second pad area on the display panel 100. That is, the circuit board 220 may be disposed on an end portion of the display panel 100, and may be spaced apart from the driving circuit chip 210 in the second direction D2.

The driving circuit chip 210 and the circuit board 220 may be electrically connected to the display panel 100. As described above, as the bending area BA is bent along the bending axis extending in the first direction D1, a portion of the display panel 100 on which the driving circuit chip 210 and the circuit board 220 are mounted may be positioned under the display panel 100.

The driving circuit chip 210 and the circuit board 220 may provide driving signals to the display panel 100. The driving signals may include a driving voltage, a gate signal, a data signal, or the like for driving the display panel 100. The driving signals may be transmitted to the pixels PX disposed in the display area DA through a plurality of pads and a plurality of transmission lines.

The cover panel 300 is disposed under the display panel 100. The cover panel 300 may be attached on a lower surface of the display panel 100. The cover panel 300 may cover the display area DA of the display panel 100. The cover panel 300 may further cover at least a portion of the non-display area NDA of the display panel 100.

The cover panel 300 may protect the display panel 100 from an external environment under the display panel 100 (e.g., impact, electromagnetic waves, noise, or the like). In addition, the cover panel 300 may diffuse heat generated in the display panel 100, and may reduce or prevent transfer to the display panel 100 of the heat generated from electronic components such as a processor, a battery, a memory, or the like, which may be positioned under the display panel 100 in an electronic device.

The display panel 100 to which the cover panel 300 are attached may be assembled with various sets (e.g., a bracket, a housing, a cover window, the electronic components, or the like) and may be provided as various types of the electronic device.

The protective film 400 is disposed under the cover panel 300. The protective film 400 may be attached on a lower surface of the cover panel 300. The protective film 400 may be configured to protect the display panel 100 and the cover panel 300 during a process in providing or manufacturing the electronic device. The protective film 400 may remain attached under the cover panel 300 until the display panel 100 having the cover panel 300 attached thereto are assembled with the set. Accordingly, the protective film 400 may protect the display panel 100 and the cover panel 300 before assembly with the set. In assembly of the set with the display panel 100, the protective film 400 may be peeled off from the cover panel 300. The protective film 400 may be referred to as a release film.

For example, the display panel 100, the cover panel 300 which is attached under the display panel 100, and the protective film 400 which is attached under the cover panel 300 may define the display module DM. In addition, although not illustrated in the drawing, the display module DM may further include various components such as a cover window, an upper protective film, or the like which are attached on the display panel 100. Detailed configurations of the cover panel 300 and the protective film 400 will be described later.

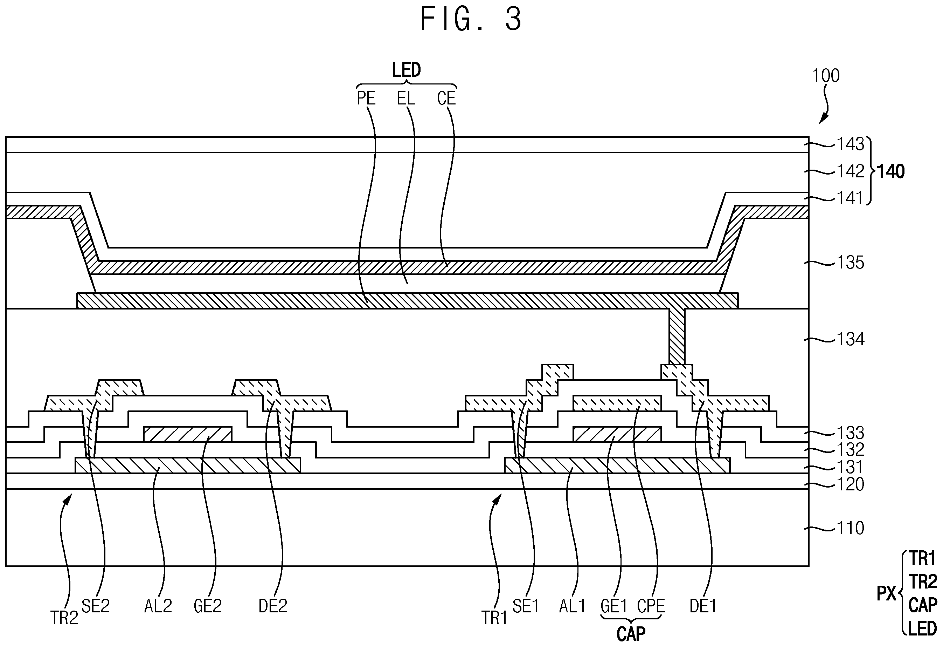

FIG. 3 is a cross-sectional view schematically illustrating a display area DA of the display panel 100 included in the display module DM of FIGS. 1A and 1B.

Hereinafter, the display area DA of the display panel 100 will be described in more detail with reference to FIG. 3.

Referring to FIG. 3, the display panel 100 may include a substrate 110, a buffer layer 120, the pixel PX, and an encapsulation layer 140. The pixel PX may include a first transistor TR1, a second transistor TR2, a capacitor CAP, and a light emitting element LED.

The substrate 110 may be an insulating substrate formed of a transparent material or a non-transparent material. In an embodiment, the substrate 110 may include a plastic. In this case, the display panel 100 may be a flexible display panel. In an embodiment, the substrate 110 may include a glass. In this case, the display panel 100 may be a rigid display panel.

The buffer layer 120 may be disposed on the substrate 110. The buffer layer 120 may prevent or reduce impurities such as oxygen or moisture from penetrating into an upper portion of the substrate 110 through the substrate 110. The buffer layer 120 may include an inorganic material such as a silicon compound, a metal oxide, or the like. For example, the buffer layer 120 may include silicon oxide (SiOₓ), silicon nitride (SiNₓ), silicon oxynitride (SiOₓN_{y}), silicon oxycarbide (SiOₓC_{y}), silicon carbonitride (SiCₓN_{y}), aluminium oxide (AlOₓ), aluminium nitride (AlN_{X}), tantalum oxide (TaOₓ), hafnium oxide (HfOₓ), zirconium oxide (ZrOₓ), titanium oxide (TiOₓ), or the like. These can be used alone or in a combination thereof. The buffer layer 120 may have a single-layered structure or a multi-layered structure including a plurality of insulating layers.

The first transistor TR1, the second transistor TR2, and the capacitor CAP may be disposed on the buffer layer 120. The first transistor TR1 may include an active layer AL1, a gate electrode GE1, a source electrode SE1, and a drain electrode DE1. The first transistor TR1 may be a driving transistor connected to the light emitting element LED. The second transistor TR2 may include an active layer AL2, a gate electrode GE2, a source electrode SE2, and a drain electrode DE2. The second transistor TR2 may be a switching transistor connected to a data line.

The active layers AL1 and AL2 may be disposed on the buffer layer 120. Each of the active layers AL1 and AL2 may include an oxide semiconductor, a silicon semiconductor, an organic semiconductor, or the like. For example, the oxide semiconductor may include at least one oxide of indium (In), gallium (Ga), tin (Sn), zirconium (Zr), vanadium (V), hafnium (Hf), cadmium (Cd), germanium (Ge), chromium (Cr), titanium (Ti), or zinc (Zn). The silicon semiconductor may include an amorphous silicon, a polycrystalline silicon, or the like. Each of the active layers AL1 and AL2 may include a source area, a drain area, and a channel area positioned between the source area and the drain area.

A first insulating layer 131 may be disposed on the active layers AL1 and AL2. The first insulating layer 131 may cover the active layers AL1 and AL2 on the buffer layer 120. The first insulating layer 131 may include an inorganic insulating material.

The gate electrodes GE1 and GE2 may be disposed on the first insulating layer 131. The gate electrode GE1 may overlap the channel area of the active layer AL1, and the gate electrode GE2 may overlap the channel area of the active layer AL2. Each of the gate electrodes GE1 and GE2 may include a conductive material such as a metal, an alloy, a conductive metal nitride, a conductive metal oxide, a transparent conductive material, or the like. For example, Each of the gate electrodes GE1 and GE2 may include gold (Au), silver (Ag), aluminium (Al), platinum (Pt), nickel (Ni), titanium (Ti), palladium (Pd), magnesium (Mg), calcium (Ca), lithium (Li), chromium (Cr), tantalum (Ta), tungsten (W), copper (Cu), molybdenum (Mo), scandium (Sc), neodymium (Nd), iridium (Ir), alloys containing aluminium, alloys containing silver, alloys containing copper, alloys containing molybdenum, aluminum nitride (AlNₓ), tungsten nitride (WNₓ), titanium nitride (TiNₓ), chromium nitride (CrNₓ), tantalum nitride (TaNₓ), strontium ruthenium oxide (SrRuOₓ), zinc oxide (ZnOₓ), indium tin oxide (ITO), tin oxide (SnOₓ), indium oxide (InOₓ), gallium oxide (GaOₓ), indium zinc oxide (IZO), or the like. These can be used alone or in a combination thereof. Each of the gate electrodes GE1 and GE2 may have a single-layered structure or a multi-layered structure including a plurality of conductive layers.

A second insulating layer 132 may be disposed on the gate electrodes GE1 and GE2. The second insulating layer 132 may cover the gate electrodes GE1 and GE2 on the first insulating layer 131. The second insulating layer 132 may include an inorganic insulating material.

A capacitor electrode CPE may be disposed on the second insulating layer 132. The capacitor electrode CPE may overlap the gate electrode GE1. The gate electrode GE1, the second insulating layer 132, and the capacitor electrode CPE may form the capacitor CAP.

A third insulating layer 133 may be disposed on the capacitor electrode CPE. The third insulating layer 133 may cover the capacitor electrode CPE on the second insulating layer 132. The third insulating layer 133 may include an inorganic insulating material.

The source electrodes SE1 and SE2 and the drain electrodes DE1 and DE2 may be disposed on the third insulating layer 133. The source electrode SE1 and the drain electrode DE1 may be connected to the source area and the drain area of the active layer AL1, respectively. The source electrode SE2 and the drain electrode DE2 may be connected to the source area and the drain area of the active layer AL2, respectively. Each of the source electrodes SE1 and SE2 and the drain electrodes DE1 and DE2 may include a conductive material.

A fourth insulating layer 134 may be disposed on the source electrodes SE1 and SE2 and the drain electrodes DE1 and DE2. The fourth insulating layer 134 may include an organic insulating material. For example, the fourth insulating layer 134 may include photoresist, polyacryl-based resin, polyimide-based resin, polyamide-based resin, siloxane-based resin, acryl-based resin, epoxy-based resin, or the like. These can be used alone or in a combination thereof.

A pixel electrode PE may be disposed on the fourth insulating layer 134. The pixel electrode PE may include a conductive material. The pixel electrode PE may be connected to the drain electrode DE1 through a contact hole formed in the fourth insulating layer 134. Accordingly, the pixel electrode PE may be electrically connected to the first transistor TR1.

A fifth insulating layer 135 may be disposed on the pixel electrode PE. The fifth insulating layer 135 may cover a peripheral portion of the pixel electrode PE, and may define a pixel opening exposing a central portion of the pixel electrode PE. The fifth insulating layer 135 may include an organic insulating material.

An emission layer EL may be disposed on the pixel electrode PE. The emission layer EL may be disposed in the pixel opening of the fifth insulating layer 135. In some embodiments, the emission layer EL may include at least one of an organic light emitting material or quantum dot.

In an embodiment, the organic light emitting material may include a low molecular weight organic compound or a high molecular weight organic compound. Examples of the low molecular weight organic compound may include copper phthalocyanine, N,N'-diphenylbenzidine, tris-(8-hydroxyquinoline)aluminium, or the like. Examples of the high molecular weight organic compound may include poly(3,4-ethylenedioxythiophene), polyaniline, poly-phenylenevinylene, polyfluorene, or the like. These can be used alone or in a combination thereof.

In an embodiment, the quantum dot may include a core including a Group II-VI compound, a Group III-V compound, a Group IV-VI compound, a Group IV element, and/or a Group IV compound. In an embodiment, the quantum dot may have a core-shell structure including the core and a shell surrounding the core. The shell may serve as a protection layer for preventing the core from being chemically denatured to maintain semiconductor characteristics, and may serve as a charging layer for imparting electrophoretic characteristics to the quantum dot.

A common electrode CE may be disposed on the emission layer EL. The common electrode CE may also be disposed on the fifth insulating layer 135. The common electrode CE may include a conductive material. The pixel electrode PE, the emission layer EL, and the common electrode CE may form the light emitting element LED.

The encapsulation layer 140 may be disposed on the common electrode CE. The encapsulation layer 140 may include at least one inorganic encapsulation layer and at least one organic encapsulation layer. In an embodiment, the encapsulation layer 140 may include a first inorganic encapsulation layer 141 disposed on the common electrode CE, an organic encapsulation layer 142 disposed on the first inorganic encapsulation layer 141, and a second inorganic encapsulation layer 143 disposed on the organic encapsulation layer 142. In addition, although not illustrated in the drawing, various functional layers such as a touch sensing layer, a color filter layer, a light collecting layer, or the like may be additionally disposed on the encapsulation layer 140.

Hereinafter, the cover panel 300 and the protective film 400 will be described in more detail with reference to FIGS. 1A to 2 again.

The cover panel 300 may have a multi-layered structure including a plurality of layers. In an embodiment, as illustrated in FIG. 2, the cover panel 300 may include an impact absorbing layer 320, a heat dissipation layer 340, a shielding layer 360, and adhesive layers 310, 330, and 350. The impact absorbing layer 320, the heat dissipation layer 340, the shielding layer 360, and the adhesive layers 310, 330, and 350 may be stacked in the third direction D3, which is a thickness direction.

The adhesive layer 310 for attaching the cover panel 300 to the display panel 100 may be disposed on an upper surface of the cover panel 300. For example, embossed patterns may be formed in an upper surface of the adhesive layer 310 attached under the display panel 100. The embossed pattern may discharge air bubbles to the outside during the attaching process of the cover panel 300.

The impact absorbing layer 320 may be disposed under the adhesive layer 310. In an embodiment, the impact absorbing layer 320 may include a first support layer 321, a cushion layer 323, and a second support layer 325.

The first and second support layers 321 and 325 may be plastic layers including a polymer such as polyethylene terephthalate (PET), polyimide (PI), or the like. For example, the first support layer 321 may include PET, and the second support layer 325 may include PI, but embodiments are not limited thereto

At least one of the first support layer 321 and the second support layer 325 may be colored. For example, the first support layer 321 may be colored. For example, the first support layer 321 may be black. The first support layer 321 may absorb light incident on the first support layer 321.

The cushion layer 323 may be a porous layer formed of a material such as polyurethane, polyethylene, or the like. The cushion layer 323 may include a foam resin. The cushion layer 323 may include an elastomer.

Adhesive layers 322 and 324 may be respectively disposed between the first support layer 321 and the cushion layer 323 and between the cushion layer 323 and the second support layer 325 to attach them.

The heat dissipation layer 340 may be disposed under the impact absorbing layer 320. The heat dissipation layer 340 may dissipate heat generated from the electronic components such as the processor, the battery, the memory, or the like. The heat dissipation layer 340 may include a material having excellent heat conductivity. For example, the heat dissipation layer 340 may include a carbon material such as graphite, graphene, carbon nanotube (CNT), or the like.

The heat dissipation layer 340 may have a plurality of openings 340OP that penetrate the body of the heat dissipation layer 340 in the thickness direction (e.g., in the third direction D3).

The adhesive layer 330 and/or the adhesive layer 350 may be extended into the openings 340OP of the heat dissipation layer 340 not only to improve bonding force of the heat dissipation layer 340 and the impact absorbing layer 320 to each other and/or the heat dissipation layer 340 and the shielding layer 360 to each other, but also to prevent or reduce separation of the heat dissipation layer 340 from other layers within the cover panel 300. For example, when the heat dissipation layer 340 includes graphite, the graphite has a relatively weak delamination force, so that the heat dissipation layer 340 may be peeled off or separated from another layer during a rework process of separating a member (e.g., a frame, a printed circuit board, a battery, or the like) attached under the cover panel 300 during the process in providing or manufacturing the electronic device. The adhesive layers 330 and 350 on both of opposing sides of the heat dissipation layer 340 are connected to each other at the openings 340OP of the heat dissipation layer 340 to relatively firmly attach the heat dissipation layer 340 to other layers within the cover panel 300 and prevent or reduce the heat dissipation layer 340 from peeling off another layer.

The adhesive layers 310, 322, 324, 330, and 350 may be a pressure sensitive adhesive film (PSA), an optically clear adhesive film (OCA), an optically clear resin (OCR), or the like.

The shielding layer 360 may be disposed under the heat dissipation layer 340. The shielding layer 360 may prevent or reduce electromagnetic waves, static electricity, noise, or the like from flowing from an external environment under the cover panel 300 to the display panel 100. In addition, the shielding layer 360 may improve a heat dissipation characteristics of the heat dissipation layer 340. The shielding layer 360 may be a metal layer including a metal having excellent thermal conductivity along with shield performance such as copper, aluminium, or the like. In addition, the shielding layer 360 may be electrically connected to a set ground which may serve as a ground after assembly with the set such that static electricity flowing into the display panel 100 and/or the cover panel 300 can be discharged to the outside.

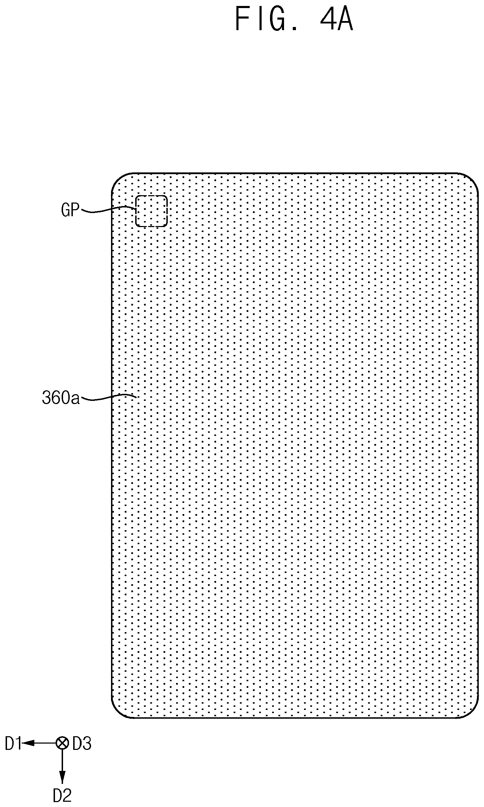

FIGS. 4A to 4C are rear views illustrating various examples of a shielding layer included in the display module of FIGS. 1A and 1B. For example, each of FIGS. 4A to 4C may correspond to the rear view of FIG. 1B.

Referring to FIGS. 1A, 1B, and 4A, in an embodiment, a shielding layer 360a may have a planar shape that entirely covers the display area DA of the display panel 100. After assembly with the set, a ground portion GP of the shielding layer 360a may be electrically connected to the set ground.

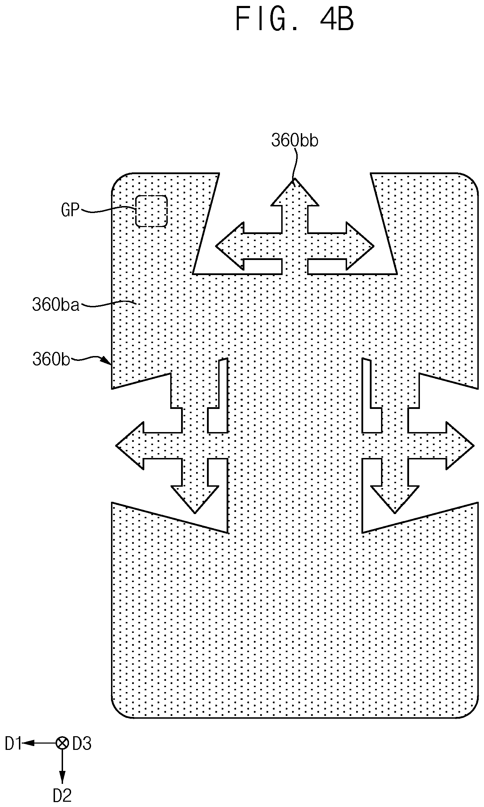

Referring to FIGS. 1A, 1B, and 4B, in an embodiment, a shielding layer 360b may include a body portion 360ba and at least one static electricity induction pattern portion 360bb. The body portion 360ba may have a recess portion that is recessed from an outer edge of the body portion 360ba in an inner direction. The static electricity induction pattern portion 360bb may protrude from the recess portion of the body portion 360ba, and may have a pointed end shape. As the shielding layer 360b includes the static electricity induction pattern portion 360bb having a pointed end shape, static electricity may be induced to be discharged to the outside more effectively. FIG. 4B illustrates that the shielding layer 360b includes three static electricity induction pattern portions 360bb, but embodiments are not limited thereto. For example, the shielding layer 360b may include one, two, or four or more static electricity induction pattern portions 360bb.

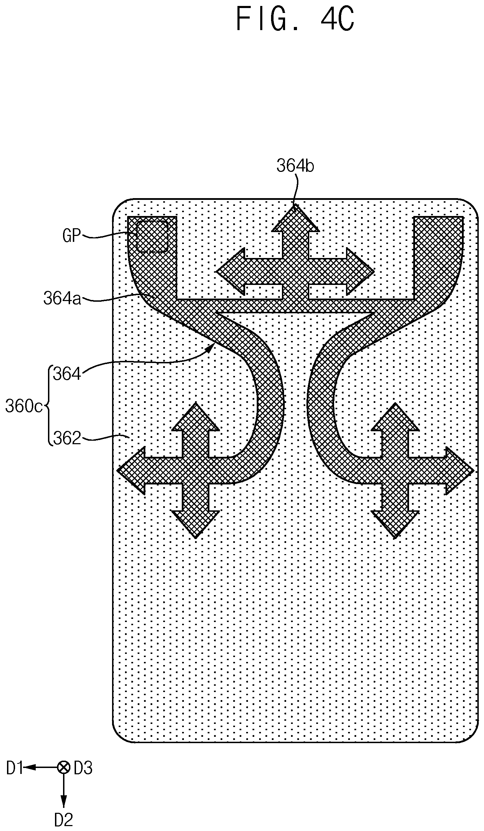

Referring to FIGS. 1A, 1B, and 4C, in an embodiment, a shielding layer 360c may include a first layer 362 and a second layer 364 disposed under the first layer 362 and electrically connected to the first layer 362. For example, the first layer 362 may have a planar shape that entirely covers the display area DA of the display panel 100.

The second layer 364 may include a connecting portion 364a and at least one static electricity induction pattern portion 364b. The static electricity induction pattern portion 364b may have a pointed end shape. FIG. 4C illustrates that the second layer 364 includes three static electricity induction pattern portions 364b, but embodiments are not limited thereto. For example, the second layer 364 may include one, two, or four or more static electricity induction pattern portions 364b.

An adhesive layer may be disposed between the first layer 362 and the second layer 364. The adhesive layer may bond the first layer 362 and the second layer 364 to each other. The first layer 362 and the second layer 364 may be electrically connected to each other. For example, the adhesive layer may have an opening that overlaps a portion of the second layer 364. A portion of the first layer 362 and the portion of the second layer 364 may contact each other through the opening of the adhesive layer, so that the first layer 362 and the second layer 364 may be electrically connected to each other.

Referring again to FIGS. 1A to 2, the protective film 400 may include a conductive adhesive layer 410, a protective layer 420, and a protruding member 430.

The conductive adhesive layer 410 for attaching the protective film 400 to the cover panel 300 may be disposed on an upper surface of the protective film 400. The conductive adhesive layer 410 may have conductivity. An upper surface of the conductive adhesive layer 410 may contact a lower surface of the shielding layer 360. For example, the conductive adhesive layer 410 may have a planar shape corresponding to a planar shape of the cover panel 300. For example, the conductive adhesive layer 410 may have a planar shape corresponding to the planar shape of the shielding layer 360. The conductive adhesive layer 410 may attach the protective layer 420 and the protruding member 430 to under the cover panel 300.

The protective layer 420 may be disposed under the conductive adhesive layer 410. An upper surface of the protective layer 420 may contact a lower surface of the conductive adhesive layer 410. The protective layer 420 may include a plastic layer including a polymer such as PET, PI, or the like. Although the protective layer 420 is illustrated as a single-layer structure in FIG. 2, the protective layer 420 may have a multi-layer structure including a plurality of layers. For example, the protective layer 420 may have a multi-layer structure in which a dissolvable adhesive layer, a masking layer, a step compensation layer, or the like is disposed between the plastic layer and the conductive adhesive layer 410, but embodiments are not limited thereto.

The protective layer 420 may have a recess portion 420r that exposes a portion of the conductive adhesive layer 410. That is, a lower surface of the portion of the conductive adhesive layer 410 may be exposed without being covered by the protective layer 420. For example, as illustrated in FIG. 1B, the recess portion 420r may be recessed from an outer edge of the protective layer 420 (e.g., an edge in the first direction D1) in an inner direction (e.g., a direction opposite to the first direction D1). FIG. 1B illustrates that the protective layer 420 has two recess portions 420r, but embodiments are not limited thereto. For example, the protective layer 420 may have one or three or more recess portions 420r, and the recess portion 420r may be formed at various edges of the protective layer 420.

The protruding member 430 may be disposed under the conductive adhesive layer 410 to correspond to the recess portion 420r of the protective layer 420. For example, the protruding member 430 may be disposed on the same layer as the protective layer 420. FIG. 1B illustrates that the protective film 400 includes two protruding members 430, but this is exemplary and embodiments are not limited thereto. For example, one or three or more protruding members 430 may be provided corresponding to a number of the recess portions 420r of the protective layer 420.

An upper surface of a portion of the protruding member 430 may contact the lower surface of the conductive adhesive layer 410. The protruding member 430 may have conductivity. For example, the protruding member 430 may include the same material as the shielding layer 360, such as a metal (e.g., copper, aluminium, or the like). For another example, the protruding member 430 may include a material different from a material of the shielding layer 360.

The protruding member 430 may include a first portion 430a and a second portion 430b. The first portion 430a of the protruding member 430 may overlap the portion of the conductive adhesive layer 410 exposed by the recess portion 420r of the protective layer 420. An upper surface of the first portion 430a of the protruding member 430 may contact the lower surface of the portion of the conductive adhesive layer 410 exposed by the recess portion 420r of the protective layer 420. For example, as illustrated in FIG. 1B, the first portion 430a of the protruding member 430 may have a planar shape corresponding to a planar shape of the recess portion 420r of the protective layer 420. That is, in a plan view, the first portion 430a of the protruding member 430 may have a shape to be inserted into the recess portion 420r of the protective layer 420. In a plan view, the first portion 430a of the protruding member 430 may overlap the shielding layer 360.

The second portion 430b of the protruding member 430 may extend from the first portion 430a in one direction (e.g., in the first direction D1). In a plan view, the second portion 430b of the protruding member 430 may protrude from the shielding layer 360 in one direction (e.g., in the first direction D1). The first portion 430a and the second portion 430b of the protruding member 430 may be integrally provided. The second portion 430b of the protruding member 430 may be a grip portion that helps facilitate removal of the protective film 400 from the cover panel 300 when assembly with the set.

As described above, the upper surface of the conductive adhesive layer 410 may contact the lower surface of the shielding layer 360, and the lower surface of the conductive adhesive layer 410 may contact the upper surface of the protective layer 420 and an upper surface of the first portion 430a of the protruding member 430. A first adhesive force between the lower surface of the shielding layer 360 and the upper surface of the conductive adhesive layer 410 may be less than a second adhesive force between the lower surface of the conductive adhesive layer 410 and the upper surface of the protective layer 420. In addition, the first adhesive force between the lower surface of the shielding layer 360 and the upper surface of the conductive adhesive layer 410 may be less than a third adhesive force between the lower surface of the conductive adhesive layer 410 and the upper surface of the first portion 430a of the protruding member 430. Accordingly, when removing the protective film 400 from the cover panel 300 for assembly with the set, the protective film 400 including the conductive adhesive layer 410 can be easily removed from the cover panel 300.

In addition, the protruding member 430 may function as a discharge path for discharging static electricity flowing into the display panel 100 and/or the cover panel 300 to the outside in a state in which the protective film 400 is attached under the cover panel 300. As described above, after removing the protective film 400 and assembly with the set, the shielding layer 360 may be electrically connected to the set ground to discharge static electricity flowing into the display panel 100 and/or the cover panel 300 to the outside. However, even before the shielding layer 360 is electrically connected to the set ground (i.e., even before assembly with the set), it is necessary to discharge static electricity flowing into the display panel 100 and/or the cover panel 300 to the outside.

For example, during the process in providing or manufacturing the electronic device, various processes or tests (e.g., driving test) may be performed on the display module DM with the cover panel 300 and the protective film 400 attached under the display panel 100 in a state in which the display module DM is seated on a jig of various equipment. At this time, a lower surface of the protruding member 430 may contact an upper surface of the jig. According to embodiments, as the protruding member 430 having conductivity is attached to the shielding layer 360 through the conductive adhesive layer 410, static electricity flowing into the display panel 100 and/or the cover panel 300 may be discharged to the outside (e.g., to the jig) through the shielding layer 360, the conductive adhesive layer 410, and the protruding member 430. That is, the protruding member 430 may function as a discharge path for discharging static electricity flowing into the display panel 100 and/or the cover panel 300 to the outside before assembly with the set. Accordingly, it is possible to prevent or reduce a change in element characteristics of transistors in the display panel 100 due to static electricity flowing into the display panel 100 before assembly with the set. Accordingly, reliabilities of the display panel 100, the display module DM, and the electronic device may be improved.

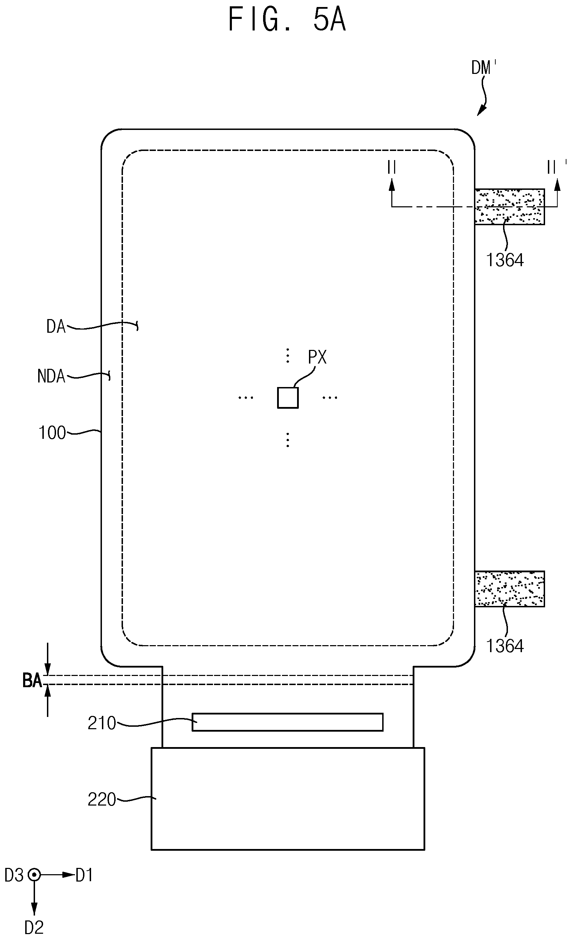

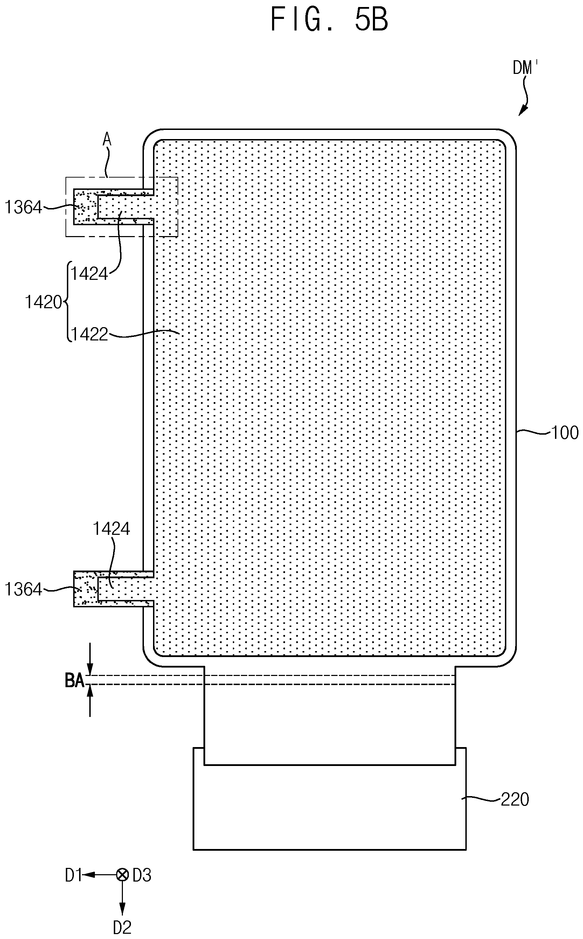

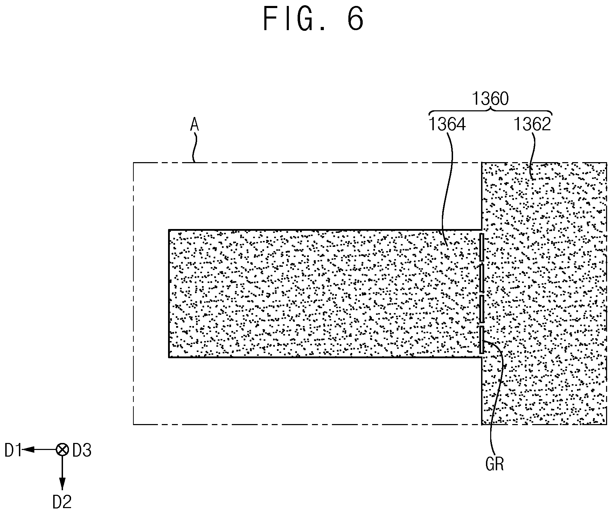

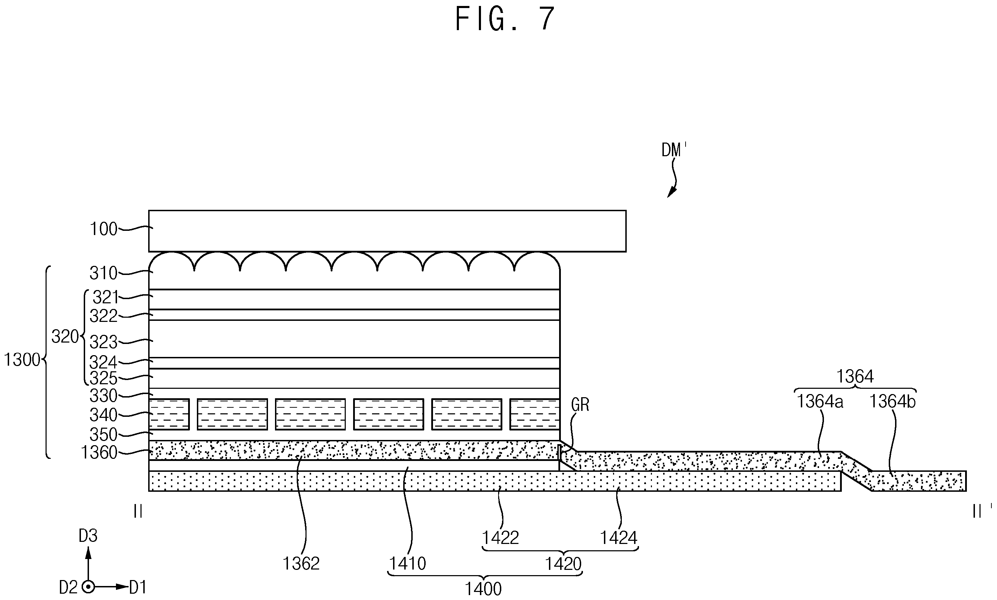

FIGS. 5A and 5B are a top view and a rear view illustrating a display module DM' according to an embodiment. FIG. 6 is an enlarged view of area A of FIG. 5B. FIG. 7 is a cross-sectional view taken along a line II-II' of FIG. 5 A.

Referring to FIGS. 5A to 7, a display module DM' according to an embodiment may include a display panel 100, a driving circuit chip 210, a circuit board 220, a cover panel 1300, and a protective film 1400. The cover panel 1300 may include an impact absorbing layer 320, a heat dissipation layer 340, a shielding layer 1360, and adhesive layers 310, 330, and 350. The protective film 1400 may include an adhesive layer 1410 and a protective layer 1420. The display module DM' may be substantially the same as or similar to the display module DM described with reference to FIGS. 1A to 4C except for the shielding layer 1360 and the protective film 1400. Therefore, repeated descriptions may be omitted or simplified.

The shielding layer 1360 may be disposed under the heat dissipation layer 340. The shielding layer 1360 may include a body portion 1362 and a first protrusion 1364. For example, the body portion 1362 of the shielding layer 1360 may have a planar shape that entirely covers the display area DA of the display panel 100. That is, the shielding layer 1360 may have a shape in which the first protrusion 1364 is additionally provided to the shielding layer 360a illustrated in FIG. 4A. For another example, the shielding layer 1360 may have a shape in which the first protrusion 1364 is additionally provided to the shielding layer 360b illustrated in FIG. 4B. For still another example, the shielding layer 1360 may have a multi-layer structure including an upper layer and a lower layer as illustrated in FIG. 4C, and the shielding layer 1360 may have a shape in which the first protrusion 1364 is additionally provided to the upper layer (the first layer 362 of FIG. 4C).

The first protrusion 1364 of the shielding layer 1360 may protrude from the body portion 1362 in one direction (e.g., in the first direction D1). The body portion 1362 and the first protrusion 1364 of the shielding layer 1360 may be integrally provided. FIG. 5B illustrates that the shielding layer 1360 includes two first protrusions 1364, but embodiments are not limited thereto. For example, the shielding layer 1360 may include one or three or more first protrusions 1364.

The adhesive layer 1410 for attaching the protective film 1400 to the cover panel 1300 may be disposed on an upper surface of the protective film 1400. An upper surface of the adhesive layer 1410 may contact a lower surface of the shielding layer 1360. For example, the adhesive layer 1410 may have a planar shape overlapping and corresponding to a planar shape of the body portion 1362 of the shielding layer 1360. The adhesive layer 1410 may overlap the body portion 1362 of the shielding layer 1360, and may not overlap the first protrusion 1364 of the shielding layer 1360. That is, the adhesive layer 1410 may expose the first protrusion 1364 of the shielding layer 1360. The upper surface of the adhesive layer 1410 may contact a lower surface of the body portion 1362 of the shielding layer 1360, and the adhesive layer 1410 may not contact a lower surface of the first protrusion 1364 of the shielding layer 1360.

The protective layer 1420 may be disposed under the adhesive layer 1410. The protective layer 1420 may include a body portion 1422 and a second protrusion 1424. For example, the body portion 1422 of the protective layer 1420 may have a planar shape overlapping and corresponding to the planar shape of the body portion 1362 of the shielding layer 1360.

The second protrusion 1424 of the protective layer 1420 may correspond to the first protrusion 1364 of the shielding layer 1360. The second protrusion 1424 of the protective layer 1420 may protrude from the body portion 1422 in one direction (e.g., in the first direction D1). The body portion 1422 and the second protrusion 1424 of the protective layer 1420 may be integrally provided. FIG. 5B illustrates that the protective layer 1420 includes two second protrusions 1424, but embodiments are not limited thereto. For example, the protective layer 1420 may include one or three or more second protrusions 1424 corresponding to the first protrusion 1364 of the shielding layer 1360.

The second protrusion 1424 of the protective layer 1420 may overlap the first protrusion 1364 of the shielding layer 1360. The second protrusion 1424 of the protective layer 1420 may have a smaller size than the first protrusion 1364 of the shielding layer 1360. For example, as illustrated in FIG. 5B, the first protrusion 1364 of the shielding layer 1360 may entirely overlap the second protrusion 1424 of the protective layer 1420 in a plan view.

The first protrusion 1364 of the shielding layer 1360 may include a first portion 1364a and a second portion 1364b positioned outside the first portion 1364a. The first portion 1364a may be a portion that overlaps the second protrusion 1424 in a plan view, and the second portion 1364b may be a portion that does not overlap the second protrusion 1424 in a plan view. For example, a lower surface of the first portion 1364a of the first protrusion 1364 of the shielding layer 1360 may contact an upper surface of the second protrusion 1424 of the protective layer 1420. For example, the second portion 1364b may surround the first portion 1364a that overlaps the second protrusion 1424 in a plan view. The second protrusion 1424 of the protective layer 1420 may expose the second portion 1364b of the first protrusion 1364 of the shielding layer 1360. That is, a lower surface of the second portion 1364b of the first protrusion 1364 of the shielding layer 1360 may be exposed without being covered by the second protrusion 1424 of the protective layer 1420.

The first protrusion 1364 of the shielding layer 1360 and the second protrusion 1424 of the protective layer 1420 may be grip portions that help facilitate removal of the protective film 1400 from the cover panel 1300 when assembly with the set. For example, when assembly with the set, the first protrusion 1364 of the shielding layer 1360 may be separated from the body portion 1362 and may be removed together with the protective film 1400.

In an embodiment, as illustrated in FIGS. 6 and 7, in order for the first protrusion 1364 of the shielding layer 1360 to be easily separated from the body portion 1362, the shielding layer 1360 may have at least one groove GR formed at a boundary between the body portion 1362 and the first protrusion 1364. FIG. 6 illustrates that the shielding layer 1360 has four grooves GR disposed in the second direction D2, but embodiments are not limited thereto. For example, the shielding layer 1360 may have one, two, three, or five or more grooves GR.

For example, as illustrated in FIG. 7, the groove GR may be formed from the lower surface of the shielding layer 1360 in the upper direction (e.g., in the third direction D3). For another example, the groove GR may be formed from the upper surface of the shielding layer 1360 in the lower direction (e.g., in the direction opposite to the third direction D3). For still another example, the groove GR may be formed to penetrate the shielding layer 1360 in the thickness direction.

As described above, the upper surface of the adhesive layer 1410 may contact the lower surface of the shielding layer 1360 (e.g., the lower surface of the body portion 1362), and the lower surface of the adhesive layer 1410 may contact the upper surface of the protective layer 1420 (e.g., the upper surface of the body portion 1422). A fourth adhesive force between the lower surface of the shielding layer 1360 and the upper surface of the adhesive layer 1410 may be less than a fifth adhesive force between the lower surface of the adhesive layer 1410 and the upper surface of the protective layer 1420. Accordingly, when removing the protective film 1400 from the cover panel 1300 for assembly with the set, the protective film 1400 including the adhesive layer 1410 can be easily removed from the cover panel 1300.

In addition, the first protrusion 1364 of the shielding layer 1360 may function as a discharge path for discharging static electricity flowing into the display panel 100 and/or the cover panel 1300 to the outside in a state in which the protective film 1400 is attached under the cover panel 1300. As described above, after removing the protective film 1400 and assembly with the set, the shielding layer 1360 may be electrically connected to the set ground to discharge static electricity flowing into the display panel 100 and/or the cover panel 300 to the outside. However, even before the shielding layer 1360 is electrically connected to the set ground (i.e., even before assembly with the set), it is necessary to discharge static electricity flowing into the display panel 100 and/or the cover panel 1300 to the outside.

For example, during the process in providing or manufacturing the electronic device, various processes or tests (e.g., driving test) may be performed on the display module DM' with the cover panel 1300 and the protective film 1400 attached under the display panel 100 in a state in which the display module DM' is seated on a jig of various equipment. At this time, as the first protrusion 1364 of the shielding layer 1360 is formed larger than the second protrusion 1424 of the protective layer 1420, a portion of the lower surface of the second portion 1364b of the first protrusion 1364 of the shielding layer 1360, which is exposed without being covered by the second protrusion 1424 of the protective layer 1420, may contact an upper surface of the jig. According to embodiments, static electricity flowing into the display panel 100 and/or the cover panel 1300 may be discharged to the outside (e.g., to the jig) through the second portion 1364b of the first protrusion 1364 of the shielding layer 1360. That is, the first protrusion 1364 of the shielding layer 1360 may function as a discharge path for discharging static electricity flowing into the display panel 100 and/or the cover panel 1300 to the outside before assembly with the set. Accordingly, it is possible to prevent or reduce a change in element characteristics of transistors in the display panel 100 due to static electricity flowing into the display panel 100 before assembly with the set. Accordingly, reliabilities of the display panel 100, the display module DM', and the electronic device may be improved.

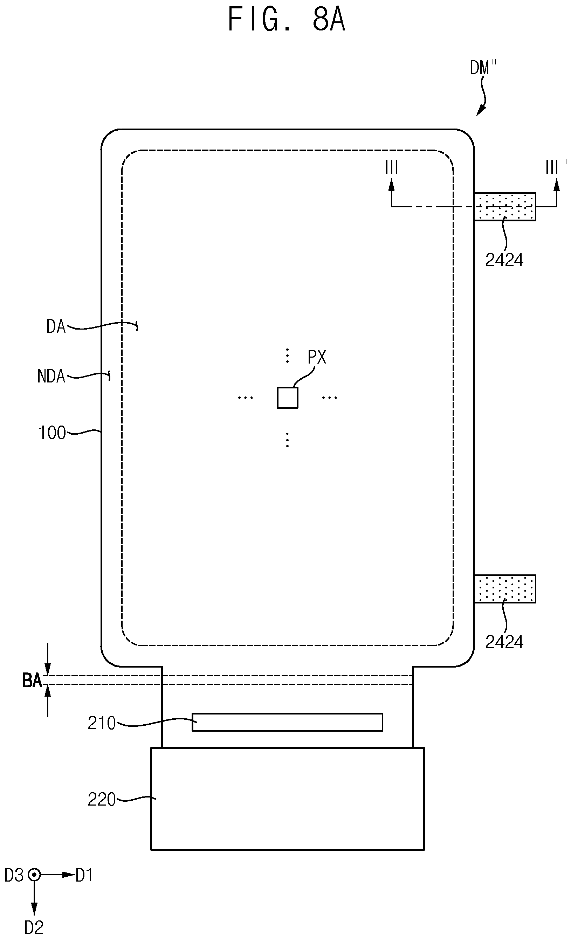

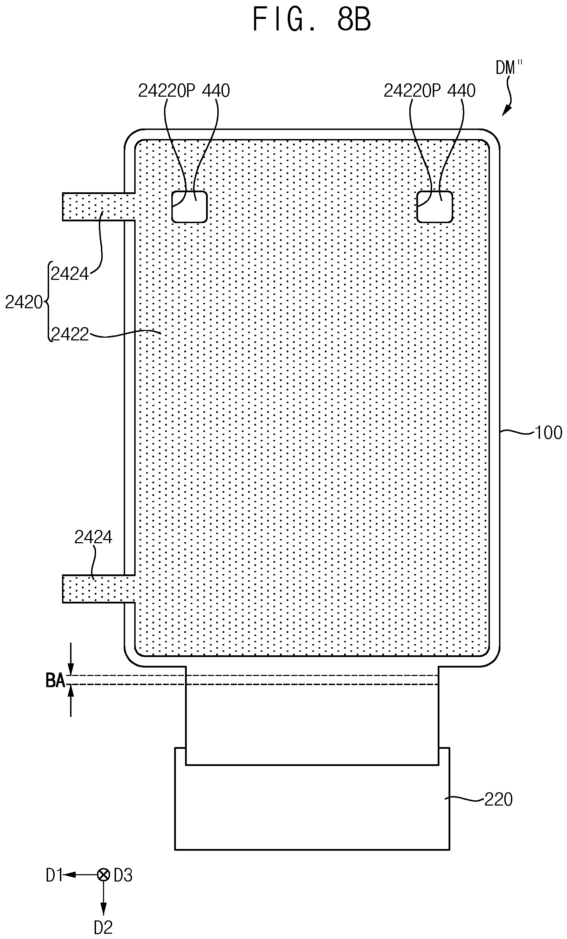

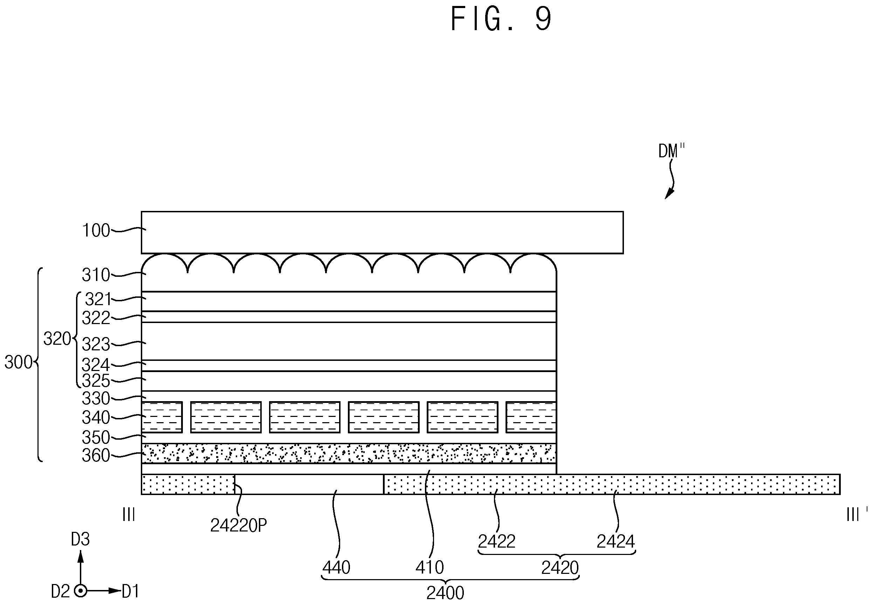

FIGS. 8A and 8B are a top view and a rear view illustrating a display module DM" according to an embodiment. FIG. 9 is a cross-sectional view taken along a line III-III' of FIG. 8A.

Referring to FIGS. 8A to 9, a display module DM" according to an embodiment may include a display panel 100, a driving circuit chip 210, a circuit board 220, a cover panel 300, and a protective film 2400. The cover panel 300 may include an impact absorbing layer 320, a heat dissipation layer 340, a shielding layer 360, and adhesive layers 310, 330, and 350. The protective film 2400 may include a conductive adhesive layer 410, a protective layer 2420, and a conductive layer 440. The display module DM" may be substantially the same as or similar to the display module DM described with reference to FIGS. 1A to 4C except for the protective layer 2420 and the conductive layer 440 of the protective film 2400. Therefore, repeated descriptions may be omitted or simplified.

The conductive adhesive layer 410 for attaching the protective film 2400 to the cover panel 300 may be disposed on an upper surface of the protective film 2400. The conductive adhesive layer 410 may have conductivity. An upper surface of the conductive adhesive layer 410 may contact the lower surface of the shielding layer 360. For example, the conductive adhesive layer 410 may have a planar shape overlapping and corresponding to the planar shape of the cover panel 300. For example, the conductive adhesive layer 410 may have a planar shape overlapping and corresponding to the planar shape of the shielding layer 360. The conductive adhesive layer 410 may attach the protective layer 2420 and the conductive layer 440 under the cover panel 300.

The protective layer 2420 may be disposed under the conductive adhesive layer 410. The protective layer 2420 may include a body portion 2422 and a protrusion 2424. For example, the body portion 2422 of the protective layer 2420 may have a planar shape corresponding to the planar shape of the shielding layer 360.

The body portion 2422 of the protective layer 2420 may have at least one opening 2422OP that penetrates the body portion 2422 in the thickness direction (e.g., in the third direction D3). FIG. 8B illustrates that the body portion 2422 of the protective layer 2420 has two openings 2422OP, but embodiments are not limited thereto. For example, the body portion 2422 of the protective layer 2420 may have one or three or more openings 2422OP.

The protrusion 2424 of the protective layer 2420 may protrude from the body portion 2422 in one direction (e.g., in the first direction D1). The body portion 2422 and the protrusion portion 2424 of the protective layer 2420 may be integrally provided. FIG. 8B illustrates that the protective layer 2420 includes two protrusions 2424, but embodiments are not limited thereto. For example, the protective layer 2420 may include one or three or more protrusions 2424. The protrusion 2424 of the protective layer 2420 may be a grip portion that helps facilitate removal of the protective film 2400 from the cover panel 300 when assembly with the set.

The conductive layer 440 may be positioned within the opening 2422OP of the body portion 2422 of the protective layer 2420. The conductive layer 440 may be disposed under the conductive adhesive layer 410. For example, the conductive layer 440 may be disposed on the same layer as the protective layer 2420. FIG. 8B illustrates that the protective film 2400 includes two conductive layers 440, but embodiments are not limited thereto. For example, the conductive layer 440 may be provided one or three or more corresponding to a number of openings 2422OP of the body portion 2422 of the protective layer 2420.

An upper surface of the conductive layer 440 may contact the lower surface of the conductive adhesive layer 410. The conductive layer 440 may have conductivity. In an embodiment, the conductive layer 440 may be a conductive tape. For example, the conductive layer 440 may be a single-sided conductive tape having an upper surface with an adhesive property. The upper surface of the conductive layer 440 may have an adhesive property, and a lower surface of the conductive layer 440 may not have an adhesive property.

As described above, the upper surface of the conductive adhesive layer 410 may contact the lower surface of the shielding layer 360, and the lower surface of the conductive adhesive layer 410 may contact an upper surface of the protective layer 2420 (e.g., an upper surface of the body portion 2422) and the upper surface of the conductive layer 440. A sixth adhesive force between the lower surface of the shielding layer 360 and the upper surface of the conductive adhesive layer 410 may be less than a seventh adhesive force between the lower surface of the conductive adhesive layer 410 and the upper surface of the protective layer 2420. In addition, the sixth adhesive force between the lower surface of the shielding layer 360 and the upper surface of the conductive adhesive layer 410 may be less than an eighth adhesive force between the lower surface of the conductive adhesive layer 410 and the upper surface of the conductive layer 440. Accordingly, when removing the protective film 2400 from the cover panel 300 for assembly with the set, the protective film 2400 including the conductive adhesive layer 410 can be easily removed from the cover panel 300.

In addition, the conductive layer 440 may function as a discharge path for discharging static electricity flowing into the display panel 100 and/or the cover panel 300 to the outside in a state in which the protective film 2400 is attached under the cover panel 300. As described above, after removing the protective film 2400 and assembly with the set, the shielding layer 360 may be electrically connected to the set ground to discharge static electricity flowing into the display panel 100 and/or the cover panel 300 to the outside. However, even before the shielding layer 360 is electrically connected to the set ground (i.e., even before assembly with the set), it is necessary to discharge static electricity flowing into the display panel 100 and/or the cover panel 300 to the outside.

For example, during the process in providing or manufacturing the electronic device, various processes or tests (e.g., driving test) may be performed on the display module DM" with the cover panel 300 and the protective film 2400 attached under the display panel 100 in a state in which the display module DM" is seated on a jig of various equipment. At this time, a lower surface of the conductive layer 440 may contact an upper surface of the jig. According to embodiments, as the conductive layer 440 having conductivity is attached to the shielding layer 360 through the conductive adhesive layer 410, static electricity flowing into the display panel 100 and/or the cover panel 300 may be discharged to the outside (e.g., to the jig) through the shielding layer 360, the conductive adhesive layer 410, and the conductive layer 440. That is, the conductive layer 440 may function as a discharge path for discharging static electricity flowing into the display panel 100 and/or the cover panel 300 to the outside before assembly with the set. Accordingly, it is possible to prevent or reduce a change in element characteristics of transistors in the display panel 100 due to static electricity flowing into the display panel 100 before assembly with the set. Accordingly, reliabilities of the display panel 100, the display module DM", and the electronic device may be improved.

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A display module comprising:
a display panel including a plurality of pixels;
a cover panel disposed under the display panel and including a shielding layer including a metal; and
a protective film disposed under the cover panel, and including:
a conductive adhesive layer disposed under the shielding layer and having conductivity;
a protective layer disposed under the conductive adhesive layer and including a recess portion exposing a portion of the conductive adhesive layer; and
a protruding member disposed under the conductive adhesive layer, having conductivity, and including a first portion overlapping the portion of the conductive adhesive layer exposed by the recess portion of the protective layer and a second portion extending from the first portion in a first direction.

2. The display module of claim 1, wherein the conductive adhesive layer contacts a lower surface of the shielding layer, an upper surface of the protective layer, and an upper surface of the first portion of the protruding member.

3. The display module of claim 2, wherein a first adhesive force between the lower surface of the shielding layer and an upper surface of the conductive adhesive layer is less than each of a second adhesive force between a lower surface of the conductive adhesive layer and the upper surface of the protective layer and a third adhesive force between the lower surface of the conductive adhesive layer and the upper surface of the first portion of the protruding member.

4. The display module of any one of claims 1 to 3, wherein:
(i) in a plan view,
the first portion of the protruding member overlaps the shielding layer, and
the second portion of the protruding member protrudes from the shielding layer in the first direction; and/or
(ii) the recess portion of the protective layer is recessed from an outer edge of the protective layer in a direction opposite to the first direction.

5. The display module of any one of claims 1 to 4, wherein:
(i) the conductive adhesive layer has a planar shape overlapping a planar shape of the shielding layer; and/or
(ii) the protruding member and the shielding layer include a same material.

6. The display module of any one of claims 1 to 5, wherein:
(i) the shielding layer includes a body portion and at least one static electricity induction pattern portion; or
(ii) the shielding layer includes:
a first layer;
a second layer disposed under the first layer, electrically connected to the first layer, and including at least one static electricity induction pattern portion; and
an adhesive layer disposed between the first layer and the second layer.

7. The display module of any one of claims 1 to 6, wherein the cover panel further includes:
an impact absorbing layer including a cushion layer; and
a heat dissipation layer disposed between the impact absorbing layer and the shielding layer.

8. A display module comprising:
a display panel including a plurality of pixels;
a cover panel disposed under the display panel and including a shielding layer, the shielding layer including a metal and including a first protrusion protruding in a first direction; and
a protective film disposed under the cover panel, and including:
an adhesive layer disposed under the shielding layer; and
a protective layer disposed under the adhesive layer and including a second protrusion, the second protrusion protruding in the first direction, overlapping the first protrusion, and having a size smaller than a size of the first protrusion.

9. The display module of claim 8, wherein
the adhesive layer contacts a lower surface of the shielding layer and an upper surface of the protective layer, and
the adhesive layer exposes each of the first protrusion and the second protrusion.

10. The display module of claim 9, wherein the first protrusion includes a first portion overlapping the second protrusion and a second portion positioned outside the first portion, optionally wherein the second protrusion exposes the second portion of the first protrusion.

11. The display module of claim 9 or claim 10, wherein an adhesive force between the lower surface of the shielding layer and an upper surface of the adhesive layer is less than an adhesive force between a lower surface of the adhesive layer and the upper surface of the protective layer.

12. The display module of any one of claims 8 to 11, wherein
the first protrusion protrudes from a body portion of the shielding layer in the first direction, and
the shielding layer has at least one groove formed between the body portion and the first protrusion.

13. A display module comprising:
a display panel including a plurality of pixels;
a cover panel disposed under the display panel and including a shielding layer including a metal; and
a protective film disposed under the cover panel, and including:
a conductive adhesive layer disposed under the shielding layer;
a protective layer disposed under the conductive adhesive layer and including a body portion having an opening and a protrusion protruding from the body portion in a first direction; and
a conductive layer disposed under the conductive adhesive layer, and positioned within the opening of the body portion of the protective layer, and having conductivity.

14. The display module of claim 13, wherein the conductive adhesive layer contacts a lower surface of the shielding layer, an upper surface of the protective layer, and an upper surface of the conductive layer, optionally wherein an adhesive force between the lower surface of the shielding layer and an upper surface of the conductive adhesive layer is less than each of an adhesive force between a lower surface of the conductive adhesive layer and the upper surface of the protective layer and an adhesive force between the lower surface of the conductive adhesive layer and the upper surface of the conductive layer.

15. The display module of claim 13 or claim 14, wherein the conductive layer is a single-sided conductive tape having an upper surface with an adhesive property, the upper surface of the single-sided conductive tape contacting the conductive adhesive layer.
